(19) Europäisches Patentamt
European Patent Office
Office européen des brevets

(11) **EP 2 063 696 B1**

(12) **EUROPÄISCHE PATENTSCHRIFT**

(45) Veröffentlichungstag und Bekanntmachung des Hinweises auf die Patenterteilung:
**22.08.2012 Patentblatt 2012/34**

(51) Int Cl.:
*H05K 7/20* (2006.01)      *H01L 23/427* (2006.01)

(21) Anmeldenummer: **08075899.8**

(22) Anmeldetag: **24.11.2008**

(54) **Verfahren zum Kühlen thermisch hochbelasteter Bauelemente und Vorrichtung zur Durchführung des Verfahrens**

Method for cooling high thermal charged construction elements and device for carrying out the method

Procédé destiné à refroidir des composants hautement chargés thermiquement et dispositif destiné à l'exécution du procédé

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **23.11.2007 DE 102007056783**
              **23.11.2007 DE 202007016535 U**

(43) Veröffentlichungstag der Anmeldung:
**27.05.2009 Patentblatt 2009/22**

(73) Patentinhaber:
• **MiCryon Technik GmbH**
  **06484 Quedlinburg (DE)**
• **Hellwig, Udo, Prof. Dr.**
  **12351 Berlin (DE)**

(72) Erfinder: **Schulz, Andreas Dr.**
  **06484 Quedlinburg (DE)**

(74) Vertreter: **Schneider, Henry et al**
  **Anwaltskanzlei**
  **Gulde Hengelhaupt Ziebig & Schneider**
  **Wallstrasse 58/59**
  **10179 Berlin (DE)**

(56) Entgegenhaltungen:
   **WO-A1-01/78478**      **WO-A2-02/42703**
   **DE-U1- 20 311 452**    **US-A1- 2004 069 451**

**Beschreibung**

Die Erfindung betrifft ein Verfahren zum Kühlen thermisch hochbelasteter Bauelemente unter Verwendung des Siedekühlens mit einem einen Wärmeübertrager aufweisenden Verdampfer, insbesondere zur Kühlung von elektronischen Bauelementen auf die der Verdampfer aufgesetzt, von einem Fluid überflossen ist, das mittels einer kreislaufförmigen Strömung einem Kondensator zugeführt wird sowie eine Vorrichtung zur Durchführung des Verfahrens.

Die schnelle Entwicklung in der Hochleistungselektronik bringt ständig neue kompaktere Bauteile mit wachsenden Leistungsdichten und hohen Verlustwärmen hervor. Wärmemengen von 10 kW auf Flächen unterhalb 200 cm$^2$ sind praktisch mit Standards einer Kühlkörpertechnik des bekannten Standes der Technik nicht mehr zu handhaben. Auch die schon für elektronische Bauelemente eingesetzte Kühlung mittels Wasser kommt bei hohen Wärmemengen an technisch nicht überschreitbare Grenzen, so dass neue Konzepte der Kühlungstechnik gefragt sind. Diese neuen Techniken stellen hohe Anforderungen an die Realisierung der Wärmeabführung, um stabile Betriebstemperaturen zu gewährleisten. Für die Größe des Wärmetransportes ist die konkrete Ausgestaltung von Wärmeübertragern sehr kompliziert, die mit speziell ausgestalteten Kondensatoren zu verbinden sind, deren Wärmeübertragungsleistung an das sekundäre Kühlmittel sowie die Tropfenbildung des Kondensats gebunden sind. Die Form und wie das Kondensat die kondensierenden Oberflächen überflutet und diese zum Verdampfer zurückleitet, sind von entscheidender Bedeutung. Die DE OS 101 02 689 zeigt eine Kühlvorrichtung, mit der das Kühlmittel komprimiert an das zu kühlende Bauteil herangeführt wird, und ein Mittel zur Dekompression des Kühlmittels. Bei dieser Vorrichtung handelt es sich offenkundig um eine Wärmepumpe, die im T-S-Diagramm die Umkehrung des Clausius-Rankine-Prozesses darstellt. Das Verdampferteil und das Kondensatorteil stehen unter relativ hohem Druck und müssen dementsprechend abgedichtet werden. Dabei wird lediglich ein seit Jahrzehnten bekanntes Kühlverfahren vorgestellt, ohne auf die spezifischen Probleme, nämlich die Besonderheiten der Oberflächenstruktur der Wärmeübertragungsflächen sowie die Form der Kühlmittel einzugehen. Aus der DE OS 100 07 066 ist eine Kühlvorrichtung der gattungsgemäßen Art bekannt geworden, bei der eine Wärmeübertragungsplatine aus Aluminium oder einer ähnlichen Legierung mit einem Verdampferteil in einen Bereich eines Elektronikbauteiles hineinragt, wobei das Verdampferteil durch eine Wand getrennt zu einem Kondensatorteil weitergeführt wird, welches mit einer möglichst großen, sichtbar berippten Wärmeübertragungsfläche in Kontakt gebracht und mit einem sekundären Kühlmittel verbunden ist. Mittels weiterer Offenbarung erfolgt bei dieser Kühlvorrichtung der Rücktransport des kondensierten primären Kühlmittels unter Schwerkraft. Aus dem erkennbaren Missverhältnis der Wärmeübertragungsflächen des Verdampferteils zum Kondensatorteil ist deutlich, dass bei der vorgestellten Kühlvorrichtung nur ein äußerst begrenzter Wärmemengenngentransport von einem thermisch belasteten Bauteil, insbesondere einem Elektronikbauteil, an das Kühlmittel gewährleistet ist.

Die DE OS 100 17 971 offenbart eine Kühlvorrichtung der entsprechenden Gattung, bei der ein Rücktransport des im Kondensatorteil kondensierten Kühlmittels entweder über eine dort nicht dargestellte Pumpe oder unter Schwerkraft zurück in das Verdampferteil erfolgt. Die Kühlvorrichtung soll aus einem Mikrowärmeübertrager bestehen, dessen Verdampferteil das Kühlmittel teilweise verdampfen lässt und die flüssige sowie die Dampfphase des primären Kühlmittels zu einem nicht näher bezeichneten Kondensatorteil leitet, in welchem die Dampfphase verflüssigt und erneut unter Schwerkraft oder mittels eine Pumpe zum Verdampferteil zurückgeführt wird. Die erfindungsgemäße Lösung ist jedoch nicht ausreichend offenbart und kann nur von einem mit der Lösung solcher Aufgaben betrauten Fachmann mitgelesen werden, ohne dass sie einen Offenbarungsgehalt darstellen kann. Der Mikrowärmeübertrager soll durch eine Vielzahl von durchströmten Kanälen eine relativ vergrößerte Wärmeübertragungsfläche bilden, die wiederum von einem geeigneten primären sowie sekundären Kühlmittel beaufschlagt werden können. Die erkennbar aufgabenhafte Offenbarung zeigt jedoch keinen konkreten Hinweis auf die spezifische Ausbildung des Verdampferteiles sowie des dazugehörigen Kondensators. Der Verdampfer ist in bekannter Weise dargestellt und seine Wärmeübertragungsleistung ist, wie der Schrift zu entnehmen, unzureichend. Wie effektiv dabei die Wärmemengen durch eine Film- oder Blasenverdampfung vom thermisch belasteten Bauteil auf das primäre Kühlmittel übertragen werden können, hängt stark von den Eigenschaften der Oberflächenstruktur, nämlich von der Größe der Oberfläche, der Kapillarität und Benetzungsrate, von seiner Porosität und der mechanischen Festigkeit des Wärmeübertragerteiles innerhalb des Verdampfers ab. Es ist aus der DE OS 103 33 871 bekannt, ein mit einem thermisch belasteten Bauelement insbesondere der Leistungselektronik wärmeübertragend gekoppeltes Verdampferteil aus einer Vielzahl von matrixartig angeordneten Stäben, Rohren, Ebenen oder gekrümmten Platten oder einer Kombination davon aus Kupfer oder Aluminium auszubilden, deren Oberfläche ganz oder teilweise mit Vorsprüngen in Form von geordneten Mikrostrukturen bedeckt ist. Diese Mikrostrukturen werden galvanisch hergestellt und weisen wahlweise eine Stiftform auf, die mit ihren Längsachsen entweder senkrecht oder unter einem Winkel zur Oberfläche der Stäbe, Rohre oder Platten angeordnet sind. Mit Beachtung der hohen Wärmeleitfähigkeit von Kupfer und Aluminium können von dem Bauelement erhebliche Wärmemengen über die Basisfläche auf die Kupfer- oder Aluminiumstäbe übertragen werden. Aufgrund der angeordneten Mikrostrukturen ist deren Oberfläche mit zu dem 50igfachen gegenüber einer glatten Oberfläche vergrößert. Da die Stiftform der Mikrostrukturen stoffschlüssig mit dem Bauteil verbunden ist, wird eine große Wärmeübertragungsleistung von der Basisfläche des Verdampfers über die Oberflächenstruktur mit den stiftförmigen Vorsprüngen gesichert.

Durch die Oberflächenstruktur können sich in den Mikrostrukturen zwischen den Stiften und Vorsprüngen beim Verdampfungsprozess ungehindert Dampfblasen entwickeln, die bei einer Erhitzung der Flüssigkeit im Siedebereich mit entsprechenden Temperaturdifferenzen Dampfblasen mit großen Abmessungen entstehen lassen, deren Abriss in den offenen Hohlräumen zwischen den Mikrostrukturen erneute Dampfblasen keimen und expandieren lassen, so dass nicht nur eine hohe Blasendichte, sondern eine große Blasenfrequenz gewährleistet ist. Dementsprechend hoch ist auch die Größe des Wärmemengentransportes pro Zeiteinheit auf der Kontaktfläche des Wärmeübertragers. Die Erfindung offenbart weiterhin, dass der Kondensator gemäß der Erfindung als Rohrbündel, Stabbündel oder Plattenkondensator ausgebildet ist und die vom primären Kühlmittel beaufschlagte Seite im Verdampfer wieder mit aufgalvanisierten, gleichartigen Mikrostrukturen versehen ist, die auf die Oberfläche der Kondensatorflächen aufgebracht sind und den Verdampfungsleistungen des Wärmeübertrages des Verdampfers angepasst sind. Die Schrift offenbart spezifisch, dass die Flächendichte und die Dicke der stiftförmigen Vorsprünge beim Verdampfer sowie beim Kondensator angepasst an die Eigenschaften des verwendeten Fluids zwischen $10^2/cm^2$ und $10^8/cm^2$ bei einer Dicke von 100 $\mu$m und 0,2 $\mu$m angesiedelt sind. Es ist bekannt, stationäres Sieden unter Verwendung von Mikrostrukturen durchzuführen. Dabei werden Rohre, Vollstäbe oder Platten mit einer Mikrostruktur versehen. Bei der Verwendung von Rohren oder Vollstäben werden diese in einen Glaszylinder eingebracht, der anschließend mit einem Kältemittel gefällt wird. Danach wird das Rohr mit temperiertem Wasser durchflossen oder im Falle der Verwendung eines Vollstabes von innen mit Heizstäben erhitzt. Zur Verwendung von Platten ist ein Gehäuse entwickelt worden, dessen Rückwand gleichzeitig die Mikrostruktur trägt. Das Gehäuse, seiner Funktion entsprechend als Verdampfer zu bezeichnen, wird mit einem Kältemittel ausgefüllt und darauf anschließend mit einer Heizplatte beheizt. Die an den Rohren, Stäben und Platten durchgeführten Messungen haben gemeinsam, dass das Kältemittel, das Fluid, im "stationären" Zustand die Mikrostrukturprofile durchflutet. Während des Siedens, also des Vorganges der Wärmeübertragung, ist der Prozess sich selbst überlassen, d. h., in Abhängigkeit von der Größe des eingestellten Wärmeflusses und der Art der Mikrostruktur stellt sich ein Gleichgewicht zwischen der Dampfblasenbildung und dem Flüssigkeitstransport zu den aktiven Keimzellen in der Mikrostruktur ein. Ist die Oberflächenstruktur günstig ausgewählt, dann ist das sich einstellende Gleichgewicht ausbalanciert und wird nicht zu einer Übertemperatur führen. Im weiteren Verfahrensverlauf ist ein Zustand zu verzeichnen, bei dem das Gleichgewicht gestört wird. D. h., es bildet sich mehr Dampf an der Oberfläche der Struktur, als Flüssigkeit nachrücken kann. Das jetzt geschilderte Phänomen wird Dampf- oder Siedeform oder auch Leidenfrostphänomen genannt. In der Regel ist ein definierter kritischer Wärmefluss notwendig, um einen Siedefilmeffekt hervorzurufen. Setzt der Siedefilm ein, wirkt er stark isolierend, d. h., die Wärme kann nicht abfließen und die Temperatur des Stabes oder der Strukturplatte steigt erheblich an. In einigen Fällen kann das innerhalb einiger Sekunden eintreten und zu signifikanten Materialschäden führen.

Die US 2004/0069451 A1 offenbart eine Einrichtung zum Kühlen thermisch hochbelasteter Bauteile mit einem Verdampfer, der eine Wärmeübertragerfläche und eine durch einen Spalt beabstandete Bedeckung umfasst, wobei ein Kühlmittel durch den Spalt leitbar ist und die Wärmeübertragerfläche mit Mikrostrukturen versehen ist, so dass eine Siedekühlung realisierbar ist.

Die DE 203 11 452 U1 beschreibt eine Kühlvorrichtung, insbesondere zur Kühlung von Bauelementen der Leistungselektronik mittels eines Wärmeübertragungskreislaufes, der aus einem mit dem Elektronikbauteil wärmeübertragend gekoppelten sowie von einem primären Kühlmittel beaufschlagten Verdampferteil sowie einem extern von einem sekundären Kühlmittel beaufschlagten Kondensatorteil besteht, in dem das primäre Kühlmittel gekühlt und seine Dampfphase kondensiert ist, wobei das primäre Kühlmittel entweder unter seiner Schwerkraft oder mittels einer Pumpe vom Kondensatorteil zum Verdampferteil gefördert ist.

Der Erfindung liegt die Aufgabe zugrunde, eine Einrichtung zum Kühlen thermisch hochbelasteter Bauelemente, unter Verwendung des Siedekühlens mit einem, einen Wärmeübertrager aufweisenden Verdampfer, der mittels einer kreislaufartigen Strömungsführung mit einem Kondensator verbunden ist und eine Vorrichtung zur Durchführung des Verfahrens zu schaffen, mittels der von thermisch hoch belasteten Bauelementen mit einer Kühlvorrichtung geringen Volumens, ohne eine Volumenvergrößerung des Wärmeübertragers eine deutlich höhere Wärmemenge abgeführt werden kann.

Die Erfindung löst die Aufgabe mittels eines Verfahrens gemäß dem, mit einem Bauelement gekoppelten Verdampfer, ein als Wärmeübertrager ausgebildetes Bauteil, dem auf seiner Wärmeübertragerfläche eine Vielzahl von Mikrostrukturen und eine flache Bauform zugeordnet ist. Zwischen den Mikrostrukturen des Wärmeübertragers sowie der Bedeckung des Bauteils ist ein enger, flacher Durchflussraum gebildet, durch den mittels einer Pumpe ein elektrisch hoch isolierendes Fluid in einem Kreislauf gedrückt wird und beim Überströmen der Mikrostrukturen der Siedefilm eine sehr große Ausdehnung erhält, die bei einer Ausbreitung von ≤ 100 $\mu$m Mächtigkeit eine schnelle, wandnahe Strömung vorausgesetzt und eine Ausbreitung des Filmes gestört ist und durch den Wärmeabtrag gebildete Dampfblasen intensiv aufgenommen und zu einem Kondensator geführt werden, in dem der Dampf auf eine niedere Temperaturstufe verflüssigt und auch das Fluid auf eine geringere Temperatur als der Dampf geführt, dem Verdampfer beschleunigt wieder zugeleitet wird und mittels der erhaltenen Intensivierung der Durchflussgeschwindigkeit des Fluides zwischen der mikrostrukturierten Oberfläche des Wärmeübertragers und der durch die annähernd aufliegende Bedeckung erzeugten engen Durchlassöffnung eine Erhöhung der Dampfblasenbildung erreicht, deren Transport zum Kondensator vorgenommen wird, darin in eine Flüssigkeitsphase zurückgekühlt in den Verdampfer gelangt und mit einem Ungleichgewicht zwischen Fluid und Dampftemperatur im Verdampfer ein unterkühltes Strömungssieden erzeugt wird. Die Erfindung ist weitergeführt, wenn die auf der Wärmeübertragerfläche des Verdampfers eingearbeiteten Mikrostrukturen von dem beschleunigt fließenden Fluid mit einer geringen Mächtigkeit über- sowie durchströmt werden, das durch die Verlustwärme des zu kühlenden Bauelementes zum Sieden gebracht, in einer Dampf- und Flüssigkeitsphase in den Kondensator gepumpt und nach Verflüssigung in den Verdampfer mit unterschiedlichen Fluidund Wärmeübertragertemperaturen zusammengeführt werden. Es ist ein Vorteil der Erfindung, dass durch das druckintensivierte Durchströmen des Verdampfers mit dem Fluid eine hohe Siederate und damit eine vergrößerte Dampfblasenmenge erzeugt wird. Es ist vorteilhaft nach der Erfindung, dass die Parameter in Art und Ausbildung der Mikrostruktur, Volumen des Fluids und seinem Durchflussprofil im Verdampfer sowie der Durchströmgeschwindigkeit abgestimmt werden, um einen hohen Wärmefluss mit dem Verdampfer zu realisieren. Ausgestaltet ist die Erfindung damit, dass der Ausbildung der Mikrostruktur auf dem Wärmeübertrager des Verdampfers eine Pinhöhe von 10 $\mu$m bis 100 $\mu$m zugeordnet sind, wobei es sinnvoll ist, der Struktur eine Pinhöhe von absolut 50-100 $\mu$m zu verleihen. Es ist im Sinne der Erfindung, dass die Kondensationsflächen des Kondensators in abgestimmter Weise mit Mikrostrukturen versehen sind, die auf die Wirkungsweise des Wärmeübertragers im Verdampfer abgestimmt, eine hohe Kühlrate bei einer kleinstmöglich umlaufenden Fluidmenge generieren. Die Erfindung hat zur Durchführung des Verfahrens eine Vorrichtung zum Gegenstand, nämlich eine Vorrichtung zum Kühlen thermisch hochbelasteter Bauelemente unter Verwendung des Siedekühlens mit einem einen Wärmeübertrager aufweisenden Verdampfer, der mittels einer kreislaufartigen Strömungsführung mit einem Kondensator verbunden ist und einen Wärmeübertragungskreislauf aufweist, der aus einem mit dem Bauelement wärmeübertragend gekoppelten sowie aus einem mit einem primären Kühlmittel beaufschlagten Verdampferteil und von einem mit sekundärem Kühlmittel beaufschlagten Kondensatorteil besteht. In dem Kondensatorteil wird das primäre Kühlmittel gekühlt, seine Dampfphase kondensiert und mittels seiner Schwerkraft oder mittels einer Pumpe vom Kondensatorteil zum Verdampferteil gefördert. In dem mit dem Bauelement für eine Wärmeübertragung gekoppelten Verdampferteil sind eine Vielzahl von matrixartig auf der Basisfläche angeordneten Stäben, Rohren oder Platten gebildet, auf dessen Oberflächen Mikroporen aufgalvanisiert sind, die eine Stiftform aufweisen und sich mit ihren Längsachsen entweder senkrecht oder unter einem Winkel zur Oberfläche der Stäbe, Rohre oder Platten erstrecken, so dass der Verdampfer eine mikrostrukturierte Wärmeübertragerfläche aufweist. Über der Wärmeübertragerfläche ist eine Bedeckung angeordnet, in der Ein- und Ausgabeöffnungen für den Durchfluss des Fluides im Verdampfer eingearbeitet sind. Die Bedeckung ist sehr flach dimensioniert und überspannt die Wärmeübertragerfläche mit einem dünnen Spalt, der eine äußerst geringe Höhe gegenüber der Wärmeübertragerfläche aufweist. Durch die äußerst flache Gestaltung des Profiles des Kühlmittels, das als Fluid ausgebildet, über eine hohe Benetzungs- und Strömungswirkung verfügt, ist eine intensive Blasenbildung im Kühlmittelfluss über dem Wärmeübertrager gewährleistet. Das Fluid wird mittels einer Pumpe aus dem Verdampfer in einen Wärmekreislauf in einen Kondensator geführt. Vorteilhafterweise ist die Wärmeübertragerfläche an ihrer Oberseite mit Mikrostrukturen besetzt und weist eine ebene, plane Ausbildung auf. Es ist eine vorteilhafte Lösung nach der Erfindung, dass die Wärmeübertragerfläche des Verdampfers als flaches Modul ausgebildet ist, über dessen, mit Mikrostrukturen ausgebildete Oberfläche das Fluid strömt und durch den zwischen der Bedeckung und der Wärmeübertragerfläche ausgebildeten Durchflussspalt geringer Öffnungshöhe mit geringer Mächtigkeit, flächig geführt ist. Es ist eine Ausführungsform der Erfindung, dass der Verdampfer eine Wärmeübertragerfläche aufweist, die mit dem zu kühlenden Bauelement direkt und flächig verbunden auf der Seite der Mikrostrukturen zur Wärmeübertragung mit dem Fluid in Verbindung gebracht ist und die mit dem Bauelement verbunden, mit Mikrostrukturen besetzte Wärmeübertragerfläche einmal auf dem Bauteil vorgesehen und in vorteilhafter Weiterführung der Erfindung auch als gegenüberliegende mikrostrukturierte Wärmeübertragerfläche auf der Innenseite der Bedeckung über der Wärmeübertragerfläche eingefügt ist. Es ist eine Gestaltung der erfindungsgemäßen Lösung, dass der Verdampfer mit dem eingefügten flachen Modul ausgerüstet ist, das mit seiner, eine Innenfläche ausformenden Wärmeübertragerfläche in einer flachen Bauform ausgebildet und auf dem Bauelement zur Übertragung der Verlustwärme angeordnet ist. Einer abschließenden Ausformung der Erfindung folgend, ist der Spalt für den Durchfluss des Fluides in einer Höhe von 1 bis 10 mm ausgeführt. Die Lösung nach der Erfindung konkretisiert sich dadurch, dass der Durchflussspalt für das Fluid in dem Verdampfer über der Wärmeübertragerfläche eine Höhe von 5 mm gegenüber der Bedeckung aufweist. Das in der erfindungsgemäßen Lösung aufgeführte Modul formt die Wärmeübertragerfläche aus und folgt mit seinen Abmessungen den Konturen der Anlagefläche des Bauelementes.

Das Verfahren sowie die Vorrichtung zur Durchführung der Erfindung weisen den Vorteil auf, dass jetzt eine hochwirksame Kühlanordnung unter Verwendung von Flüssigkeiten, verbunden mit einem neuartigen Konzept des Strömungssiedens, an Wärmeübertragern mit Mikrostrukturen zur Anwendung gebracht wird. Zusammengefasst arbeitet das Verfahren mit folgenden Einzelmerkmalen.

- Als Grundlage ist das Prinzip des Siedekühlens angenommen.
- Das Verfahren setzt mikrostrukturierte Oberflächenprofile der Wärmeübertrager als Grundlage für das Verdampfen ein.

- Vorteilhaft überströmt das Wärmeübertragungsfluid im Verdampfer den mikrostrukturierten Wärmeübertrager mit hoher Geschwindigkeit bei Vorhandensein einer sehr dünnen Fluidschicht mit extrem hohen Wärmeströmen. Es entsteht ein hocheffektives Strömungssieden.
- Der im Verfahren verwendete Kondensator kann wasser- sowie luftgekühlt ausgelegt werden und erfüllt dabei zwei Aufgaben: Verflüssigung des Dampfes, Kondensation, Abkühlung des strömenden Fluides.

Es ist ein weiterer Vorteil des erfindungsgemäß entwickelten Strömungssiedens, dass neben einem Variieren der Mikrostruktur auch die lineare Flussgeschwindigkeit veränderlich eingestellt werden kann. Es besteht der Vorteil, den kritischen Wärmefluss weiter nach oben zu verschieben. Mit einer angepasst eingestellten Strömung wird der Siedefilm aufgerissen. Dadurch wird die Flüssigkeit auf der Oberfläche und in der Mikrostruktur aufgerissen und es wird ein schneller Abtransport der sich ausbildenden, die Wärme speichernden Dampfbläschen erreicht. Da der Siedefilm in seiner Mächtigkeit eine Ausdehnung von schätzungsweise 100 $\mu$m aufweist, ist eine schnelle, wandnahe Strömung notwendig, um ein Ausbreiten des Filmes zu stören. Eine einfache, bisher bekannte Durchflutung des Verdampfergehäuses ist nicht ausreichend, um die notwendigen Effekte zu erzielen. Das Gehäuse weist deshalb vorteilhaft eine extrem flache Form auf, durch die das Fluid als Kältemittel gepumpt wird. Die getroffene Wahl der Mikrostruktur und die der Spalthöhe (Gehäusehöhe) sowie die Wahl der Fluidpumpe sind zum Erreichen des erfindungsgemäßen Effektes aufeinander abgestimmt. Weitergehende Erkenntnisse zeigen, dass auch die Art der Zu- und Abläufe des Fluides bzw. das Fluid-Dampfgemisch einen nicht unerheblichen Einfluss auf die Siederate und damit auf die Wärmeübertragung haben. Vorteilhaft konnten über eine 10 cm x 10 cm erstreckte Mikrostrukturfläche bis zu 6000 W abgeführt werden. Das bedeutet, dass mit 60 W/cm$^2$ eine nie erreichte Größe der Wärmeübertragung erreicht worden ist, wobei der Siedefilm noch gar nicht vollständig optimiert wurde. Die Spaltbildung im Verdampfer beträgt dabei 6 mm und die lineare Geschwindigkeit des Siedefilmes 0,2 m/s. Vorteilhafterweise entsteht bei dem erfindungsgemäßen Verfahrensverlauf ein weiterer Effekt, dass die Strömung das Fluids im Kondensator noch zusätzlich abkühlt, so dass neben dem Sieden noch eine Kühlung durch Konvektion des Fluids über die Strukturplatte erfolgt. Nach bisherigen Messungen liegt das Fluid mit seiner Temperatur bei 20 °C, wobei die Dampftemperatur durchaus höher, bei ca. 35 °C liegen kann. An der Strukturplatte liegt ein so genanntes unterkühltes Sieden vor.

Zur Lösung der Aufgabe wird somit erfindungsgemäß eine Einrichtung zum Kühlen thermisch hochbelasteter Bauteile mit einem Verdampfer zur Verfügung gestellt, wobei der Verdampfer wenigstens eine Wärmeübertragerfläche und eine diese Wärmeübertragerfläche zumindest bereichsweise überdeckende Bedeckung umfasst und zwischen der Wärmeübertragerfläche und der Bedeckung ein Spalt ausgebildet ist, durch den ein Kühlmittel geleitet oder leitbar ist.

Wenigstens die Wärmeübertragerfläche ist zumindest gebietsweise auf der dem Kühlmittelstrom zugewandten Seite mit Mikrostrukturen versehen, wobei diese Mikrostrukturen im Wesentlichen Stiftform aufweisen. Der zwischen Wärmeübertragerfläche und Bedeckung ausgebildete Spalt weist eine derart geringe Dicke auf, dass bei bestimmten Temperaturen des zu kühlenden Bauteils und bestimmten Volumenströmen des Kühlmittels durch den Spalt ein Siedekühlen realisierbar ist.

Erfindungsgemäß ist dabei vorgesehen, dass die Dicke des Spaltes nicht größer ist als eine kritische Spaltdicke $D_{krit}$ zur Realisierung des siedefilmfreien Strömungssiedens, wobei gilt:

$$D_{krit} = KT * 1/v_{krit} * f \text{ (Mikrostruktur, } v_{krit}, \text{ Fluid),}$$

wobei eine Wärmeübertragerfläche mit einer vorgegebene Länge L, ein vorgegebenes Fluid mit bestimmter Fluiddichte p und einer spezifischen Verdampfungsenthalpie $\Delta h_v$ sowie eine bestimmte Übertemperatur $\Delta T$ verwendet werden und diese zur Konstanten KT zusammengefasst sind und $v_{krit}$ die kritische Strömungsgeschwindigkeit des Kühlmittels beziehungsweise des Fluides ist.

Bevorzugt ist das zu verwendende Kühlmittel ein Fluid, vorzugsweise eine Kühlflüssigkeit, die elektrisch hoch-isolierend wirkt.

Das Auftreten des Leidenfrost-Phänomens kann damit eliminiert oder doch zumindest wesentlich verringert werden. Es lässt sich durch den Einsatz der Mikrostruktur somit die benötigte Siedetemperatur verringern und die Kühlung wesentlich effizienter realisieren.

Bei geringer Übertemperatur lässt sich eine im Vergleich zum Stand der Technik erhöhte Wärmestromdichte einstellen und das Bauteil mit geringerem Energieeinsatz kühlen. Bei hohen Übertemperaturen lässt sich eine entsprechend hohe Wärmestromdichte realisieren.

Es kann dabei vorgesehen sein, dass der Verdampfer einen am zu kühlenden Bauteil befestigbaren oder befestigten Wärmeübertrager aufweist, wobei eine Seite des Wärmeübertragers die Wärmeübertragerfläche ausbildet.

In einer alternativen Ausgestaltung kann vorgesehen sein, dass der Verdampfer keinen Wärmeübertrager aufweist, sondern zur Leitung von Kühlmittel über eine Oberfläche des zu kühlenden Bauteils ausgestaltet ist, so dass das zu kühlende Bauteil selbst die Wärmeübertragerfläche ausbildet.

In einer besonderen Ausgestaltung der Erfindung mit erhöhtem Wirkungsgrad ist vorgesehen, dass auch die Bedeckung auf der dem Kühlmittel zugewandten Seite mit Mikrostrukturen versehen ist.

Die erwähnten Mikrostrukturen sind vorteilhafterweise aufgalvanisiert.

An einer konstruktiv optimierten Bedeckung sind Ein- und Ausgabeöffnungen angeordnet und der Rand der Bedeckung ist gegenüber dem von der Bedeckung überdeckten Bereich der Wärmeübertragerfläche zumindest kühlmitteldicht abgedichtet.

In bevorzugter Ausführungsform der Erfindung ist vorgesehen, dass die mit Mikrostrukturen besetzte Oberfläche der Wärmeübertragerfläche eben ausgeführt ist.

Das heißt, dass die mit Mikrostrukturen besetzte Oberfläche der Wärmeübertragerfläche im Wesentlichen plan ausgeführt ist. In besonderer Ausgestaltung kann vorgesehen sein, dass die Ebene, auf der die Mikrostrukturen angeordnet sind, eine konvexe Wölbung in wenigstens einer und vorzugsweise nur einer Raumdimension aufweist. Dies dient im Wesentlichen der der Aufbringung beziehungsweise Aufspannung einer Folie auf die mit der Mikrostruktur zu versehenden Fläche bei der Herstellung der Mikrostruktur.

In einer alternativen Ausführungsform kann vorgesehen sein, dass die mit Mikrostrukturen besetzte Oberfläche der Wärmeübertragerfläche daran angeordnete Stäbe, Rohre oder Platten aufweist, an denen die Mikrostrukturen angeordnet sind.

Die Erfindung umfasst nicht nur einen speziell ausgestalteten Verdampfer, sondern kann des Weiteren wenigstens einen Kondensator umfassen, der durch wenigstens eine Fluid-Leitung mit dem Verdampfer verbunden ist, und mit dem die aus dem Verdampfer kommende Dampfphase des Kühlmittels kondensiert wird oder kondensierbar ist und das Kühlmittel abgekühlt wird oder abkühlbar ist.

Zu diesem Zweck umfasst die erfindungsgemäße Einrichtung außerdem wenigstens eine Leitung vom Kondensator zum Verdampfer oder gegebenenfalls zu einem Kühlmittelreservoir und von dort zum Verdampfer, um die aus der Kondensierung der Dampfphase erhaltene Kühlflüssigkeit wieder dem Verdampfer zuzuführen oder zuführen zu können.

Zur Erhöhung des Gesamt-Wirkungsgrades ist vorgesehen, dass die Kondensationsflächen des Kondensators in abgestimmter Weise mit Mikrostrukturen versehen sind, die auf die Wirkungsweise der Wärmeübertragerfläche des Verdampfers abgestimmt und eine hohe Kühlrate bei einer kleinstmöglichen umlaufenden Fluidmenge generieren.

Vorteilhafterweise haben die Pins der Mikrostruktur auf der Wärmeübertragerfläche des Verdampfers eine Pinhöhe von 10 $\mu$m bis 100 $\mu$m, wobei verbesserte Siede- und Verdampfungsraten mit Pinhöhen von 50 $\mu$m bis 100 $\mu$m erzielbar sind.

Optimale Werte lassen sich mit Pinhöhen von 50 $\mu$m bis 60 $\mu$m realisieren.

In einer günstigen Ausgestaltung der erfindungsgemäßen Einrichtung weist deren Spalt für den Durchfluss des Kühlmittels über der Wärmeübertragerfläche eine Dicke von 1 mm bis 10 mm auf.

Besonders gute Ergebnisse des Siedekühlens lassen sich erzielen, wenn der Spalt eine Dicke von 5 mm aufweist, insbesondere bei gleichzeitiger Einstellung der anderen als bevorzugt angegebenen Parameter.

Versuche haben gezeigt, dass ein Verhältnis von der mit der Mikrostruktur versehenen Fläche (in mm$^2$) des Verdampfers zur Spaltdicke (in mm) 1000 bis 5000 (mm) betragen sollte.

Das heißt, dass der Quotient von der mit der Mikrostruktur versehenen Fläche zur Spaltdicke 1000 bis 5000 betragen sollte.

Besonders gute Ergebnisse lassen sich erzielen, wenn das Verhältnis von der mit der Mikrostruktur versehenen Fläche in mm$^2$ des Verdampfers zur Spaltdicke in mm 1400 bis 2000 mm beträgt.

Das heißt, dass der optimierte Quotient von der mit der Mikrostruktur versehenen Fläche zur Spaltdicke 1400 bis 2000 betragen sollte.

Die besten Ergebnisse des Siedekühlens stellen sich bei einem Quotienten von vorzugsweise 1600 bis 1700 ein, insbesondere bei gleichzeitiger Einstellung der anderen als bevorzugt angegebenen Parameter.

Vorzugsweise sollte das Verhältnis von Breite zur Länge der mit Mikrostruktur versehenen Fläche 1:0,7 bis 1,3 betragen; bevorzugt ist ein Verhältnis von 1:1 zu wählen.

In besonderer Ausgestaltung wird eine Einrichtung zum Kühlen thermisch hochbelasteter Bauteile zur Verfügung gestellt, deren Verdampfer mittels einer kreislaufartigen Strömungsführung mit dem Kondensator verbunden ist und die einen Wärmeübertragungskreislauf aufweist, der aus einem mit dem Bauelement wärmeübertragend gekoppelten sowie aus einem mit einem primären Kühlmittel beaufschlagten Verdampferteil und von einem mit sekundärem Kühlmittel beaufschlagten Kondensatorteil besteht, in dem das primäre Kühlmittel gekühlt, seine Dampfphase kondensiert und mittels seiner Schwerkraft oder mittels einer Pumpe vom Kondensatorteil zum Verdampferteil gefördert ist. In dem mit dem Bauelement für eine Wärmeübertragung gekoppelten Verdampferteil sind eine Vielzahl von matrixartig auf der Basisfläche angeordneten Stäben, Rohren oder Platten ausgebildet, auf dessen Oberflächen Mikroporen aufgalvanisiert sind, die eine Stiftform aufweisen und sich mit ihren Längsachsen entweder senkrecht oder unter einem Winkel zur Oberfläche der Stäbe, Rohre oder Platten erstrecken.

Der Verdampfer weist die mikrostrukturierte Wärmeübertragerfläche auf, über der die Ein- und Ausgabeöffnung aufweisende Bedeckung angeordnet ist, die spaltbreit die Wärmeübertragerfläche überspannt, wobei durch den Spalt, der eine äußerst geringe Höhe gegenüber der Wärmeübertragerfläche aufweist, ein Kühlmittel, als Fluid ausgebildet, mit hoher Benetzungsund Strömungswirkung durch eine Pumpe bewegt ist, von da dem Kondensator in einem Wärmeumlauf geführt kreislaufartig zuströmt. Die Wärmeübertragerfläche an ihrer Oberseite mit Mikrostrukturen besetzt, weist eine ebene, plane Ausbildung auf.

Des Weiteren wird ein Verfahren zum Kühlen thermisch hochbelasteter Bauteile unter Verwendung des Siedekühlens mittels der erfindungsgemäßen Einrichtung zum Kühlen thermisch hochbelasteter Bauteile zur Verfügung gestellt. Zur Durchführung des Verfahrens werden die geometrischen Abmaße des durch den Spalt im Verdampfer gebildeten Raumes, die Temperatur des zu kühlenden Bauteils und die Geschwindigkeit des Volumenstromes des Kühlmittels durch den Verdampfer derart eingestellt, dass ein unterkühltes Strömungssieden im Verdampfer erzeugt wird. Dabei wird eine Strömung durch Verdampfer erzeugt, wobei Kühlmittel bevorzugt in flüssiger Phase in Verdampfer eintritt und in zumindest teilweise dampfförmiger Phase diesen verlässt. Die Strömung wird bevorzugt durch Pumpe oder auch durch statischen Druck erzeugt.

Vorteilhafterweise ist vorgesehen, dass die Dicke des Spaltes nicht größer eingestellt wird als eine kritische Spaltdicke $D_{krit}$ zur Realisierung des siedefilmfreien Strömungssiedens, wobei gilt:

$$D_{krit} = KT * 1/v_{krit} * f ( \text{Mikrostruktur}, v_{krit}, \text{Fluid}),$$

wobei eine Wärmeübertragerfläche mit einer vorgegebene Länge L, ein vorgegebenes Fluid mit bestimmter Fluiddichte p und einer spezifischen Verdampfungsenthalpie $\Delta h_v$ sowie eine bestimmte Übertemperatur $\Delta T$ verwendet werden und diese zur Konstanten KT zusammengefasst sind und $v_{krit}$ die kritische Strömungsgeschwindigkeit des Kühlmittels beziehungsweise des Fluides ist.

Die kritische Spaltdicke $D_{krit}$ lässt sich folgendermaßen ermitteln.

Die Siedeleistung entspricht der Verlustleistung:

$$P_{Sieden} = P_{Bauteil}$$

wobei die Siedeleistung $P_{Sieden}$ durch den Term $p * A_{spalt} * v * \Delta h_v$ ausgedrückt werden kann und die Verlustleistung $P_{Bauteil}$ durch den Term $\alpha_{sieden} * A_{fläche} * \Delta T$ ausgedrückt werden kann. Zur Kühlung wird ein Kühlmittel, in der folgenden Berechnung als Fluid benannt, verwendet.

Es bezeichnet:

p:          Fluiddichte,
v:          lineare Geschwindigkeit des Fluides
$\Delta h_v$:     spez. Verdampfungsenthalpie des Fluides,
$\alpha_{sieden}$:   Wärmeübergangskoeffizient,
$\Delta T$:        Übertemperatur,
$A_{spalt}$:     Querschnittsfläche des Spaltes,
$A_{fläche}$:    Wärmeübertragerfläche.

Es ergibt sich somit die Gleichung:

$$p * A_{spalt} * v * \Delta h_v = P_{Bauteil} = \alpha_{sieden} * A_{fläche} * \Delta T$$

Die Querschnittsfläche des Spaltes $A_{spalt}$ lässt sich definieren durch:

$$A_{spalt} = B(\text{reite des Spaltes}) * D(\text{icke des Spaltes})$$

Die mit Mikrostrukturen bedeckte Fläche $A_{fläche}$ also die Wärmeübertragerfläche, lässt sich definieren durch:

$$A_{fläche} = B(reite\ der\ Fläche) * L(änge\ der\ Fläche).$$

Es ergibt sich daraus:

$$P * B * D * v * \Delta h_V = \alpha_{sieden} * B * L * \Delta T$$

B kürzt sich heraus, so dass sich ergibt:

$$D = L / (\rho * \Delta h_V) * 1/v * \alpha_{sieden} * \Delta T.$$

Bei einer vorgegebenen Länge der Wärmeübertragerfläche, einem vorgegebenen Fluid mit bestimmter Fluiddichte p und einer spezifischen Verdampfungsenthalpie $\Delta h_V$ sowie bei einer bestimmten Übertemperatur $\Delta T$ lassen sich diese Größen zu einer Konstanten KT zusammenfassen.
Es ergibt sich:

$$D = KT * 1/v * \alpha_{sieden}.$$

Der Wärmeübergangskoeffizient $\alpha_{sieden}$ hängt von der Form, Anordnung und Größe der Mikrostruktur als auch von der linearen Geschwindigkeit des Fluides und von den charakteristischen Eigenschaften des Fluides selbst sowie von spezifischen Umgebungsparametern, wie insbesondere dem Dampfdruck im Verdampfer und weiteren, vom Fachmann offensichtlich zu beachtenden Parametern, ab.

$$\alpha_{sieden} = f\ (\ Mikrostruktur,\ v,\ Fluid)$$

Es kann eine kritische Geschwindigkeit $v_{krit}$ definiert werden, also eine zur Durchführung des Verfahrens benötigte Mindestgeschwindigkeit, die ein reelles $\alpha_{sieden}$ hervorruft.

$$\alpha_{sieden} = f\ (\ Mikrostruktur,\ v_{krit},\ Fluid)$$

Gemäß der Ausgangsgleichung gilt:

$$\alpha_{sieden} := P_{Bauteil} / (\ A_{fläche} * \Delta T\ )$$

Damit kann eine kritische Spaltdicke $D_{krit}$ definiert werden, die zur Realisierung des erfindungsgemäßen siedefilmfreien Kühlens nicht überschritten werden sollte.

$$D_{krit} = KT * 1/v_{krit} * f\ (\ Mikrostruktur,\ v_{krit},\ Fluid)$$

Ein wesentlicher Faktor für die Auswahl und Einstellung der Spaltdicke ist also die kritische Strömungsgeschwindigkeit $v_{krit}$ des Fuides, da sie als Divisor sowie als Variable einer Funktion auftritt.

Es ist zu erwarten, dass die kritische Geschwindigkeit $v_{krit}$ in diesen Termen als konkurrierende Größe wirkt, wobei der Term $1/v_{krit}$ stärker wirkt, so dass davon auszugehen ist, dass je größer die kritische Geschwindigkeit $v_{krit}$ ist, umso kleiner $D_{krit}$ anzusetzen ist.

In weiterer Ausgestaltung des Verfahrens ist vorgesehen, dass das Kühlmittel nach dessen zumindest teilweiser Verdampfung einem Kondensator zur Verflüssigung und Abkühlung zugeleitet wird und danach der erneuten Verdampfung zur Verfügung gestellt wird.

Somit wird eine kreislaufartige Strömungsführung des Kühlmittels realisiert.

Bevorzugt ist vorgesehen, dass durch die Wahl und Einstellung der Spaltdicke, der Temperatur des zu kühlenden Bauteils, der Viskosität des Kühlmittels, die Größe der von der Bedeckung abgedeckten Wärmeübertragerfläche und des Drucks des Kühlmittels bei dessen Eintritt in den Verdampfer eine Geschwindigkeit des Kühlmittels von 0,1 bis 0,5 m/s eingestellt wird.

Besonders effektive Geschwindigkeitswerte liegen zwischen 0,15 und 0,3 m/s; insbesondere 0,2 m/s.

Detailliert wird ein Verfahren zum Kühlen zur Verfügung gestellt, welches unter Verwendung des Siedekühlens mit einem einen Wärmeübertrager aufweisenden Verdampfer durchgeführt wird, der mittels einer kreislaufartigen Strömungsführung mit einem Kondensator verbunden ist, wobei einem mit einem Bauelement gekoppelten Verdampfer, ein als Wärmeübertrager ausgebildetes Bauteil, dem aus seiner Wärmeübertragerfläche eine Vielzahl von Mikrostrukturen und eine flache Bauform zugeordnet wird, zwischen den Mikrostrukturen des Wärmeübertragers sowie der Bedeckung des Bauteils ein enger Durchflussraum gebildet, durch den mittels einer Pumpe ein elektrisch hoch isolierendes Fluid in einen Kreislauf gedrückt wird und beim Überströmen der Mikrostrukturen der Siedefilm eine sehr große Ausdehnung erhält, die bei einer Ausbreitung von ≤ 100 μm eine schnelle wandnahe Strömung voraussetzt und eine Ausbreitung des Filmes gestört wird, mit dem durch den Wärmeabtrag gebildete Dampfblasen intensiv aufgenommen und zu einem Kondensator geführt werden. Im Kondensator wird der Dampf auf eine niedere Temperaturstufe verflüssigt und auch das Fluid auf eine geringere Temperatur als der Dampf geführt, dem Verdampfer beschleunigt wieder zugeleitet und mittels der erhaltenen Intensivierung der Durchflussgeschwindigkeit des Fluides zwischen der mikrostrukturierten Oberfläche des Wärmeübertragers und der durch die annähernd aufliegende Bedeckung erzeugten engen Durchlassöffnung eine Erhöhung der Dampfblasenbildung erreicht, deren Transport zum Kondensator vorgenommen wird, darin in eine Flüssigkeitsphase zurückgekühlt in den Verdampfer gelangt und mit einem Ungleichgewicht zwischen Fluid- und Dampftemperatur im Verdampfer ein unterkühltes Strömungssieden erzeugt wird.

Die Erfindung soll anhand eines Ausführungsbeispieles näher erläutert werden. In der zugehörigen Zeichnung zeigen:

Fig. 1:     eine Einrichtung in ihrer Gesamtkonfiguration;
Fig. 2:     einen Verdampfer mit angefügtem Bauelement;
Fig. 3:     eine mikrostrukturierte Wärmeübertragerfläche in einer gesonderten Darstellung,

und

Fig. 4:     ein Diagramm mit einer Gegenüberstellung der Heizleistung und der Temperatur in einer erwärmten Einrichtung.

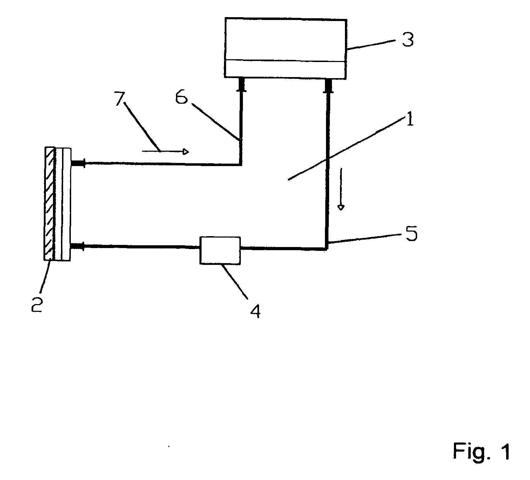

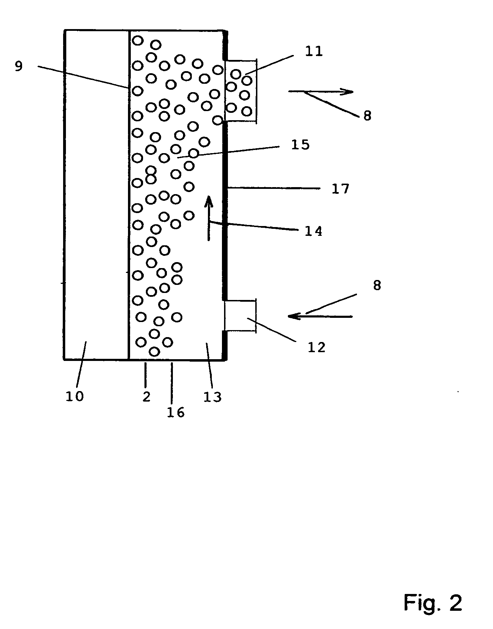

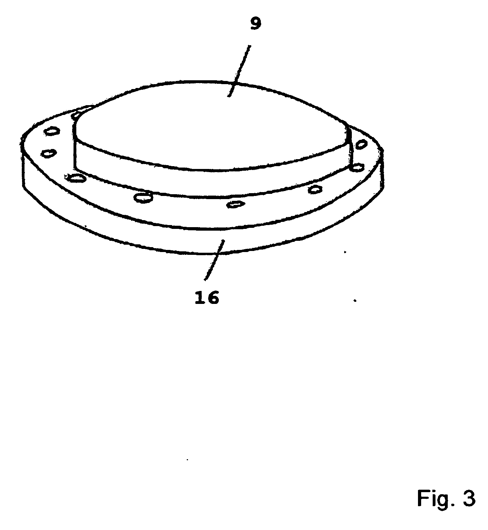

Fig. 1 stellt die Vorrichtung 1 in ihrer Gesamtkonfiguration dar. Dabei ist einem Verdampfer 2 eine Pumpe 4 vorgeordnet, welche ein elektrisch isoliertes Fluid, aus einem Kondensator 3 kommend, dem Verdampfer 2 zuführt. Im Verdampfer 2 wird das Fluid verdampft und über eine Leitung 6 dem Kondensator zugeführt und zum Kondensieren gebracht, um über die Leitung 5 der Pumpe 4 wieder zugeführt zu werden, welche das Fluid in einem erneuten Kreislauf dem Verdampfer 2 zuführt. Die Richtungspfeile 7, 8, 14 zeigen die Strömungs- und Durchlaufrichtung im Wärmekreislauf an. Der Verdampfer 2, der Kondensator 3, die Pumpe 4 sind durch Leitungen 5, 5', 6 verbunden. Fig. 2 zeigt den Verdampfer 2 in einer vergrößerten Darstellung. Das Bauelement 10 ist mit dem Verdampfer 2 in dichtem Kontakt verbunden. Der Wirkkontakt zum Bauelement 10 wird durch ein mikrostrukturiertes Bauteil in Form eines Wärmeübertragers hergestellt, dessen mikrostrukturierte Wärmeübertragerfläche 9 in den Verdampfer 2 hineinragt und mit dem durchfließenden Fluid in eine thermische Wirkverbindung gebracht wird. Das Fluid fließt in den Verdampfer 2, über den Einlass 12, der mit der Leitung 5' zur Pumpe verbunden ist und verlässt den Verdampfer 2 durch den Auslass 11 über das Rohr 6, in dem es in Richtung des Pfeiles 7 zum Verdampfer 2 gelangt und dort in einen wässrigen Aggregatzustand gebracht, gekühlt zurückgeführt wird. Der Durchflussspalt 13 zwischen der Bedeckung 17 und der Wärmeübertragerfläche 9 ist in geringer Dicke in den Dimensionen von 1 bis 10 ausgeführt, um dem Fluid die Möglichkeit zu verleihen, dünnschichtig und breitflächig mit einer gezielt eingestellten Strömungsgeschwindigkeit von 0,2 m/s über die Wärmeübertragerfläche 9 zu fließen und die Bildung von Dampfblasen 15 in den Mikrostrukturen optimal zu bewirken, welche in Richtung des Pfeiles 14 zum Auslass 11 strömen und von da aus in den Kondensator 3 gelangen. Fig. 3 zeigt die Ausbildung des strukturierten Bauteiles 16 mit der aufgearbeiteten mikrostrukturierten Wärmeübertragerfläche 9. Die Ausbildung des strukturierten flächigen Moduls 16 zeigt, dass eine intensive Verbindung des Bauteiles 16 mit dem thermisch belasteten Bauelement 10 durch die angepasste Form und intensive Verbindungsart der beiden Bauteile 10; 16, hergestellt werden kann. Für seine Wirkungsweise hat der kompakt ausgefertigte Verdampfer 2 eine Wärmeübertragerfläche 9 mit integrierten Mikrostrukturen. Die Wärmeübertragerfläche 9 wird mit dem Wärmeübertragungsfluid überströmt und durch die Verlustwärme des Bauelementes 10 zum Sieden gebracht. Das dadurch erzeugte Dampf-Fluid-Gemisch wird zum Kondensator 3 gepumpt, verflüssigt und dem Verdampfer wieder zugeführt. Der Prozess erfolgt kreislaufförmig und wiederholt, so wie es die Fig. 1 darstellt. Für die Erfindung ist die Konstruktion des Verdampfers von signifikanter Bedeutung, um große Wärmemengen abführen zu können. Der mitlesende Fachmann erkennt, dass folgende Parameter für die Verfahrensführung genau aufeinander abzustimmen sind.

Erstens die Art der Mikrostruktur auf der oder den Wärmeübertragerflächen 9 sowie zweitens das Volumen und die Durchströmungsgeschwindigkeit des Fluides. Das Wärmeübertragungsfluid wird über die Wärmeübertragerfläche 9 gepumpt und überströmt dabei seine mikrostrukturierte Kontaktfläche, die bei einer hohen Siederate eine intensive Blasenbildung des Fluides generiert. Mit einer wirksamen, wandnahen Strömung werden die Dampfblasen 15 aus dem Verdampfer 2 ausgetragen und in den Kondensator 3 transportiert. Um den Verdampfer 2 kompakt und platzsparend auszubilden, wird ein minimiertes Volumen des Verdampfers 2 angestrebt und dazu ein flaches, strukturiertes Bauteil 16 und eine dementsprechend flache Bedeckung 17 zur Anwendung gebracht. Damit wird die vorher erwähnte intensive Durchströmung des Verdampfers 2 erreicht, die ein Abtragen der in großer Anzahl gebildeten Dampfblasen 15 aus dem Verdampfer 2 ermöglicht. Das strukturierte flächige Modul 16 mit dem mikrostrukturierten Wärmeübertrager 9 ist ausführungsgemäß aus einem Aluminium- oder Edelstahlgehäuse gebildet, wobei es dem mitlesenden Fachmann nicht entgehen kann, dass auch die Innenflächen des Gehäuses des Verdampfers 2 im Bereich des Spaltes 13 mit Mikrostrukturen belegt werden können, um die Blasenbildung und damit die Kühlrate zum Abtragen der Verlustwärme auf dem Bauelement 10 zu intensivieren. Wie bereits vorstehend erwähnt, ist das zu kühlende Bauelement 10 mit der Rückwand des Modules 16 der mikrostrukturierten Wärmeübertragerfläche 9 fest in Kontakt gebracht. Die bereits vorstehend dargestellten Fakten lassen erkennen, dass sich mit der sehr geringen Kantenhöhe des Gehäuses ein geringer Durchflussspalt 13 resultieren lässt, der eine wirksame Durchflussmenge und wandnahe Strömung gewährleistet, welche ein Mitreißen der in der Mikrostruktur gebildeten Dampfblasen 15 in bisher nicht erreichtem Umfang ermöglicht.

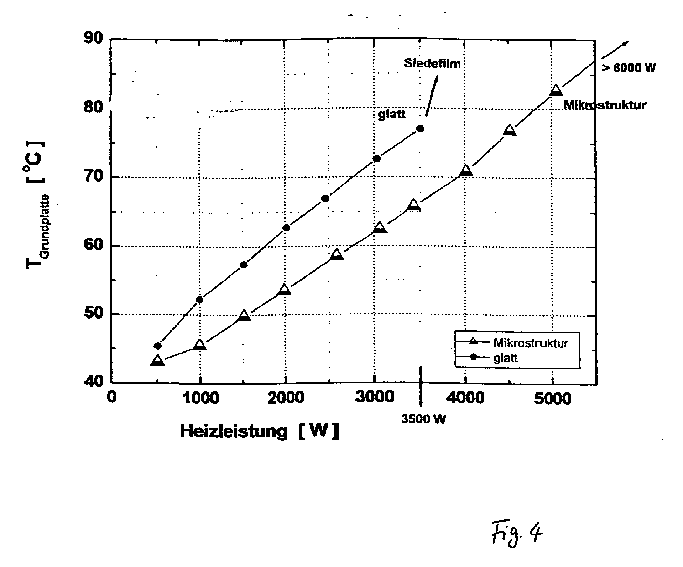

In Figur 4 ist ein Diagramm mit einer Gegenüberstellung der Heizleistung und der Temperatur in einer Einrichtung zum Erwärmen eines Fluides dargestellt. Die dargestellten Werte beziehen sich auf ein Strömungssieden mit einer Wärmeübertragerfläche von 100 cm$^2$.

Es ist ersichtlich, dass bei einer erwärmten Fläche ohne Mikrostrukturen ab einem bestimmten Leistungswert weiter Energie zugeführt wird, ohne dass sich die Temperatur des zu erwärmenden Fluides weiter erhöht. Dies ist in der Ausbildung eines Siedefilmes begründet. Das heißt, dass sich hier das Leidenfrost-Phänomen einstellt.

Bei der erfindungsgemäßen Beschichtung der Heizfläche und der richtigen Einstellung des erfindungsgemäßen engen Spaltmaßes dagegen steigt die Bauteil- und damit Heizleistung und die Temperatur in einer erwärmten Einrichtung.

Aufstellung der verwendeten Bezugszeichen

| | |
|---|---|
| 1 | Vorrichtung |
| 2 | Verdampfer |
| 3 | Kondensator |
| 4 | Pumpe |
| 5, 5', 6 | Leitung |
| 7, 8, 14 | Richtungspfeile |
| 9 | mikrostrukturierte Wärmeübertragerfläche |
| 10 | Bauelement |
| 11 | Auslass |
| 12 | Einlass |
| 13 | Durchflussspalt |
| 14 | Strömungsrichtung |
| 15 | Dampfblasen |
| 16 | strukturiertes, flaches Modul |
| 17 | Bedeckung |

**Patentansprüche**

1. Einrichtung zum Kühlen thermisch hochbelasteter Bauteile mit einem Verdampfer, der wenigstens eine Wärmeübertragerfläche und eine diese Wärmeübertragerfläche zumindest bereichsweise überdeckende Bedeckung umfasst, wobei zwischen der Wärmeübertragerfläche und der Bedeckung ein Spalt ausgebildet ist, durch den ein Kühlmittel geleitet oder leitbar ist, und wobei wenigstens die Wärmeübertragerfläche zumindest gebietsweise auf der dem Kühlmittelstrom zugewandten Seite mit Mikrostrukturen versehen ist und diese Mikrostrukturen im Wesentlichen eine Stiftform aufweisen, **dadurch gekennzeichnet, dass** der zwischen Wärmeübertragerfläche und Bedeckung ausgebildete Spalt eine derart geringe Dicke aufweist, dass bei bestimmten Temperaturen des zu kühlenden Bauteils und bestimmten Volumenströmen des Kühlmittels durch den Spalt ein Siedekühlen realisierbar ist, wobei die Dicke des Spaltes nicht größer ist als eine kritische Spaltdicke ($D_{krit}$) zur Realisierung des siedefilmfreien Strömungssiedens, wobei gilt:

$$D_{krit} = KT * 1/v_{krit} * f \,(\text{Mikrostruktur, } v_{krit}, \text{ Fluid}),$$

wobei eine Wärmeübertragerfläche mit einer vorgegebenen Länge (L), ein vorgegebenes Fluid mit bestimmter Fluiddichte (p) und einer spezifischen Verdampfungsenthalpie ($\Delta h_v$) sowie eine bestimmte Übertemperatur ($\Delta T$) verwendet werden und diese zur Konstanten (KT) zusammengefasst sind und $v_{krit}$ die kritische Strömungsgeschwin-digkeit des Kühlmittels beziehungsweise des Fluides ist.

2. Einrichtung zum Kühlen thermisch hochbelasteter Bauteile nach Anspruch 1, **dadurch gekennzeichnet, dass** der Verdampfer einen am zu kühlenden Bauteil befestigbaren oder befestigten Wärmeübertrager aufweist, wobei eine Seite des Wärmeübertragers die Wärmeübertragerfläche ausbildet.

3. Einrichtung zum Kühlen thermisch hochbelasteter Bauteile nach Anspruch 1, **dadurch gekennzeichnet, dass** der Verdampfer keinen Wärmeübertrager aufweist, sondern zur Leitung von Kühlmittel über eine Oberfläche des zu kühlenden Bauteils ausgestaltet ist, so dass das zu kühlende Bauteil selbst die Wärmeübertragerfläche ausbildet.

4. Einrichtung zum Kühlen thermisch hochbelasteter Bauteile nach wenigstens einem der vorhergehenden Ansprüche, **dadurch gekennzeichnet, dass** auch die Bedeckung auf der dem Kühlmittel zugewandten Seite mit Mikrostrukturen versehen ist.

5. Einrichtung zum Kühlen thermisch hochbelasteter Bauteile nach wenigstens einem der vorhergehenden Ansprüche, **dadurch gekennzeichnet, dass** die mit Mikrostrukturen besetzte Oberfläche der Wärmeübertragerfläche eben ausgeführt ist.

6. Einrichtung zum Kühlen thermisch hochbelasteter Bauteile nach wenigstens einem der vorhergehenden Ansprüche, **dadurch gekennzeichnet, dass** die Einrichtung des Weiteren wenigstens einen Kondensator umfasst, der durch wenigstens eine Fluid-Leitung mit dem Verdampfer verbunden ist, und mit dem die aus dem Verdampfer kommende Dampfphase des Kühlmittels kondensiert wird oder kondensierbar ist und das Kühlmittel abgekühlt wird oder abkühlbar ist.

7. Einrichtung zum Kühlen thermisch hochbelasteter Bauteile nach wenigstens einem der vorhergehenden Ansprüche, **dadurch gekennzeichnet, dass** der Ausbildung der Mikrostruktur auf der Wärmeübertragerfläche des Verdampfers eine Pinhöhe von 10 $\mu$m bis 100 $\mu$m zugeordnet ist.

8. Einrichtung zum Kühlen thermisch hochbelasteter Bauteile nach Anspruch 7, **dadurch gekennzeichnet, dass** der Ausbildung der Mikrostruktur auf der Wärmeübertragerfläche des Verdampfers eine Pinhöhe von 50 $\mu$m bis 60 $\mu$m zugeordnet ist.

9. Einrichtung zum Kühlen thermisch hochbelasteter Bauteile nach wenigstens einem der vorhergehenden Ansprüche, **dadurch gekennzeichnet, dass** der Spalt für den Durchfluss des Kühlmittels über der Wärmeübertragerfläche eine Dicke von 1 mm bis 10 mm aufweist.

10. Einrichtung zum Kühlen thermisch hochbelasteter Bauteile nach wenigstens einem der vorhergehenden Ansprüche, **dadurch gekennzeichnet, dass** das Verhältnis von der mit der Mikrostruktur versehenen Fläche in mm$^2$ des

Verdampfers zur Spaltdicke in mm 1000 bis 5000 beträgt.

**11.** Einrichtung zum Kühlen thermisch hochbelasteter Bauteile nach Anspruch 10, **dadurch gekennzeichnet, dass** das Verhältnis von der mit der Mikrostruktur versehenen Fläche in mm$^2$ des Verdampfers zur Spaltdicke in mm 1400 bis 2000 beträgt.

**12.** Verfahren zum Kühlen thermisch hochbelasteter Bauteile unter Verwendung des Siedekühlens mittels einer Einrichtung zum Kühlen thermisch hochbelasteter Bauteile gemäß wenigstens einem der Ansprüche 1 bis 11, **dadurch gekennzeichnet, dass** die geometrischen Abmaße des durch den Spalt im Verdampfer gebildeten Raumes, die Temperatur des zu kühlenden Bauteils und die Geschwindigkeit des Volumenstromes des Kühlmittels durch den Verdampfer derart eingestellt werden, dass ein unterkühltes Strömungssieden im Verdampfer erzeugt wird, wobei die Dicke des Spaltes nicht größer eingestellt wird als eine kritische Spaltdicke ($D_{krit}$) zur Realisierung des siedefilmfreien Strömungssiedens, wobei gilt:

$$D_{krit} = KT * 1/v_{krit} * f \text{ (Mikrostruktur, } v_{krit}, \text{ Fluid)},$$

wobei eine Wärmeübertragerfläche mit einer vorgegebene Länge (L), ein vorgegebenes Fluid mit bestimmter Fluiddichte (p) und einer spezifischen Verdampfungsenthalpie $\Delta h_v$ sowie eine bestimmte Übertemperatur $\Delta T$ verwendet werden und diese zur Konstanten (KT) zusammengefasst sind und $v_{krit}$ die kritische Strömungsgeschwindigkeit des Kühlmittels beziehungsweise des Fluides ist.

**13.** Verfahren zum Kühlen nach Anspruch 12, **dadurch gekennzeichnet, dass** das Kühlmittel nach dessen zumindest teilweiser Verdampfung einem Kondensator zu Verflüssigung und Abkühlung zugeleitet wird und danach der erneuten Verdampfung zur Verfügung gestellt wird.

**14.** Verfahren zum Kühlen nach wenigstens einem der Ansprüche 12 und 13, **dadurch gekennzeichnet, dass** durch die Wahl und Einstellung der Spaltdicke, der Temperatur des zu kühlenden Bauteils, der Viskosität des Kühlmittels, der Größe der von der Bedeckung abgedeckten Wärmeübertragerfläche und des Drucks des Kühlmittels bei dessen Eintritt in den Verdampfer eine Geschwindigkeit des Siedefilms von 0,1 bis 0,5 m/s eingestellt wird.

**Claims**

**1.** A device for cooling thermally highly stressed components, comprising an evaporator which comprises at least one heat transfer surface and a cover that covers at least a part of said heat transfer surface, wherein a gap is formed between the heat transfer surface and the cover, through which gap a cooling agent is passed or can be passed, and wherein at least the heat transfer surface, at least in a zone thereof, is provided with microstructures on the side facing the cooling agent stream and said microstructures are essentially pin-shaped, **characterized in that** the gap formed between the heat transfer surface and the cover has such a small width that, at certain temperatures of the component to be cooled and certain volumetric flow rates of the cooling agent through the gap, evaporative cooling can be achieved, wherein the width of the gap does not exceed a critical gap width ($D_{krit}$) required to achieve boiling-film-free flow boiling, wherein:

$$D_{krit} = KT * 1/v_{krit} * f \text{ (microstructure, } v_{krit}, \text{ fluid)},$$

wherein a heat transfer surface of a predefined length (L), a predefined fluid having a certain fluid density (p) and a specific enthalpy of vaporization ($\Delta h_v$), and a certain increase in temperature ($\Delta T$) are used and these are combined to obtain the constant (KT), and $v_{krit}$ is the critical flow rate of the cooling agent or the fluid.

**2.** A device for cooling thermally highly stressed components according to claim 1, **characterized in that** the evaporator comprises a heat exchanger that can be affixed or is affixed to the component to be cooled, wherein one side of the heat exchanger forms the heat transfer surface.

**3.** A device for cooling thermally highly stressed components according to claim 1, **characterized in that** the evaporator does not comprise a heat exchanger, but is designed to pass a cooling agent across a surface of the component to be cooled, so that the component to be cooled forms the heat transfer surface.

4.  device for cooling thermally highly stressed components according to at least one of the preceding dims, **characterized in that** the cover is also provided with microstructures on the side facing the cooling agent.

5.  A device for cooling thermally highly stressed components according to at least one of the preceding claims, **characterized in that** the surface of the heat transfer surface that is provided with microstructures is flat.

6.  A device for cooling thermally highly stressed components according to at least one of the preceding claims, **characterized in that** the device further comprises at least one condenser which is connected to the evaporator by means of at least one fluid pipe and by means of which the vapour phase of the cooling agent leaving the evaporator is condensed or can be condensed and the cooling agent is cooled down or can be cooled down.

7.  A device for cooling thermally highly stressed components according to at least one of the preceding claims, **characterized in that** the microstructure formed on the heat transfer surface of the evaporator has a pin height ranging from 10 $\mu$m to 100 $\mu$m.

8.  A device for cooling thermally highly components according to claim 7, **characterized in that** the microstructure formed on the heat transfer surface of the evaporator has a pin height ranging from 50 $\mu$m to 60$\mu$m.

9.  A device for cooling thermally highly stressed components according to at least one of the preceding claims, **characterized in that** the gap for passing the cooling agent across the heat transfer surface has a width ranging between 1 mm and 10 mm.

10. A device for cooling thermally highly stressed components according to at least one of the preceding claims, **characterized in that** the ratio of the surface in mm$^2$ of the evaporator that is provided with the microstructure to the gap width in mm ranges from 1000 to 5000.

11. A device for cooling thermally highly stressed components according to claim 10, **characterized in that** the ratio of the surface in mm$^2$ of the evaporator that is provided with the microstructure to the gap width in mm ranges from 1400 to 2000.

12. A method for cooling thermally highly stressed components using evaporative cooling by means of a device for cooling thermally highly stressed components according to at least one of claims 1 to 11, **characterized in that** the geometric dimensions of the space formed by the gap in the evaporator, the temperature of the component to be cooled and the volumetric flow rate of the cooling agent through the evaporator are adjusted in such a manner that subcooled flow boiling is achieved in the evaporator, wherein the width of the gap is not adjusted to a larger value than a critical gap width ($D_{krit}$) required to achieve boiling-film-free flow boiling, wherein:

$$D_{krit} = KT * 1/v_{krit} * f \text{ (microstructure, } v_{krit}, \text{ fluid)},$$

wherein a heat transfer surface of a predefined length (L), a predefined fluid having a certain fluid density (p) and a specific enthalpy of vaporization ($\Delta h_v$), and a certain increase in temperature ($\Delta T$) are used and these are combined to obtain the constant (KT), and $v_{krit}$ is the critical flow rate of the cooling agent or the fluid.

13. A method for cooling according to claim 12, **characterized in that** the cooling agent, once it has been evaporated at least partly, is passed to a condenser in order to be liquefied and cooled down and is then made available for evaporation again.

14. A method for cooling according to at least one of claims 12 and 13, **characterized in that** the velocity of the boiling film is adjusted to the range of 0,1 to 0,5 m/s by selecting and adjusting the gap width, the temperature of the component to be cooled, the viscosity of the cooling agent, the size of the heat transfer surface that is covered by the cover and the pressure of the cooling agent when it enters the evaporator.

**Revendications**

1. Dispositif destiné à refroidir des composants hautement chargés thermiquement avec un évaporateur qui comprend au moins une face de caloporteur et un recouvrement recouvrant au moins par une zone de cette face de caloporteur, une fente étant constituée entre la face de caloporteur et le recouvrement, à travers laquelle un produit réfrigérant est conduit ou peut être conduit, et au moins la face de caloporteur étant, au moins par un secteur, munie de microstructures sur le côté tourné vers le flux de produit réfrigérant, et ces microstructures présentant essentiellement une forme de broche, **caractérisé en ce que** la fente constituée entre la face de caloporteur et le recouvrement présente une épaisseur suffisamment mince pour que, en présence de températures définies du composant à refroidir et de flux volumiques définis du produit réfrigérant à travers la fente, un refroidissement par évaporation soit réalisable, l'épaisseur de la fente n'étant pas supérieure à une épaisseur de fente critique ($D_{krit}$) pour la réalisation de l'ébullition d'écroulement exempte de pellicule d'ébullition, la relation suivante étant valable :

$$D_{krit} = KT * 1/v_{krit} * f \text{ (microstructure, } v_{krit}, \text{ fluide)},$$

une face de caloporteur avec une longueur prédéfinie (L), un fluide prédéfini avec une densité de fluide (p) définie et une enthalpie d'évaporation spécifique ($\Delta h_v$) ainsi qu'une surtempérature ($\Delta T$) définie étant utilisés, et ceux-ci étant réunis pour former la constante (KT), et $V_{krit}$ étant la vitesse d'écoulement critique du produit réfrigérant ou du fluide.

2. Dispositif destiné à refroidir des composants hautement chargés thermiquement selon la revendication 1, **caractérisé en ce que** l'évaporateur présente un caloporteur fixé ou pouvant être fixé sur le composant à refroidir, un côté du caloporteur constituant la face de caloporteur.

3. Dispositif destiné à refroidir des composants hautement chargés thermiquement selon la revendication 1, **caractérisé en ce que** l'évaporateur ne présente pas de caloporteur, mais est constitué pour la conduite de produit réfrigérantsur une surface du composant à refroidir de sorte que le compostant à refroidir constitue lui-même la face de caloporteur.

4. Dispositif destiné à refroidir des composants hautement chargés thermiquement selon au moins une des revendications précédentes, **caractérisé en ce que** le recouvrement également est muni de microstructures sur le coté tourné vers le produit réfrigérant.

5. Dispositif destiné à refroidir des composants hautement chargés thermiquement selon au moins une des revendications précédentes, **caractérisé en ce que** la surface de la face de caloporteur occupée par des microstructures est réalisée de façon plane.

6. Dispositif destiné à refroidir des composants hautement chargés thermiquement selon au moins une des revendications précédentes, **caractérisé en ce que** le dispositif comprend en outre au moins un condenseur qui est raccordé par au moins une conduite de fluide à l'évaporateur, et avec lequel la phase vapeur du produit réfrigérant en provenance de l'évaporateur est condensée ou peut être condensée, et le produit réfrigérant est refroidi ou peut être refroidi.

7. Dispositif destiné à refroidir des composants hautement chargés thermiquement selon au moins une des revendications précédentes, **caractérisé en ce qu'**une hauteur de pin de 10 $\mu$m à 100 $\mu$m est affectée à la formation de la microstructuresur la face de caloporteur de l'évaporateur.

8. Dispositif destiné à refroidir des composants hautement chargés thermiquement selon la revendication 7, **caractérisé en ce qu'**une hauteur de pin de 50 $\mu$m à 60 $\mu$m est affectée à la formation de la microstructure sur la face de caloporteur de l'évaporateur.

9. Dispositif destiné à refroidir des composants hautement chargés thermiquement selon au moins une des revendications précédentes, **caractérisé en ce que** la fente pour le passage du produit réfrigérant sur la face de caloporteur présente une épaisseur de 1 mm à 10 mm.

10. Dispositif destiné à refroidir des composants hautement chargés thermiquement selon au moins une des revendications précédentes, **caractérisé en ce que** le rapport de la face, en mm$^2$, de l'évaporateur, munie de la microstructure à l'épaisseur de fente, en mm, est de 1000 à 5000.

**11.** Dispositif destiné à refroidir des composants hautement chargés thermiquement selon la revendication 10, **caractérise en ce que** le rapport de la face, en mm$^2$, de l'évaporateur munie de la microstructure à l'épaisseur de fente, en mm, est de 1 400 à 2 000.

**12.** Procédé destiné à refroidir des composants hautement chargés thermiquement avec utilisation du refroidissement par évaporation au moyen d'un dispositif destiné à refroidir des composants hautement chargés thermiquement selon au moins une des revendications 1 à 11, **caractérisé en ce que** les dimensions géométriques de l'espace formé par la fente dans l'évaporateur, la température du composant à refroidir et la vitesse du flux volumique du produit réfrigérant à travers l'évaporateur sont réglées de sorte qu'une ébullition d'écoulement sur refroidie est produite dans l'évaporateur, l'épaisseur de la fente n'étant pas réglée à une valeur supérieure à une épaisseur de fente critique ($D_{krit}$) pour la réalisation de l'ébullition d'écoulement exempte de pellicule d'ébullition, la relation suivante étant valable:

$$D_{krit} = KT * 1/v_{krit} * f \text{ (microstructure, } v_{krit}, \text{ fluide)},$$

uneface de caloporteur avec une longueur prédéfinie (L), un fluide prédéfini avec une densité de fluide (p) définie et une enthalpie d'évaporation spécifique ($\Delta h_v$) ainsi qu'une surtempérature ($\Delta T$) définie étant utilisés, et ceux-ci étant réunis pour former la constante (KT), et $V_{krit}$ étant la vitesse d'écoulement critique du produit réfrigérant ou du fluide.

**13.** Procédé destiné au refroidissement selon la revendication 12, **caractérisé en ce que**, après son évaporation au moins partielle, le produit réfrigérant est conduit à un condenseur pour la liquéfaction et le refroidissement, et est ensuite mis à déposition pour la nouvelle évaporation.

**14.** Procédé destiné au refroidissement selon au moins une des revendications 12 et 13, **caractérisé en ce que** le choix et le réglage de l'épaisseur de fente, de la température du composant à refroidir, de la viscosité du produit réfrigérant, de la taille de la face de caloporteur recouverte par le recouvrement et de la pression du produit réfrigérant lors de son entrée dans l'évaporateur permettent de régler une vitesse de la pellicule d'ébullition de 0,1 à 0,5 m/s.

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE OS10102689 A
- DE OS10007066 A
- DE OS10017971 A
- DE OS10333871 A
- US 20040069451 A1
- DE 20311452 U1